(19)

Europäisches
Patentamt
European
Patent Office
Office européen
des brevets

(11) **EP 1 744 211 A1**

(12) **EUROPEAN PATENT APPLICATION**

(43) Date of publication:
**17.01.2007 Bulletin 2007/03**

(51) Int Cl.:
***G03F 7/00*** (2006.01)

(21) Application number: **06253492.0**

(22) Date of filing: **04.07.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **14.07.2005 US 698943 P**
**30.08.2005 US 214049**

(71) Applicant: **ASML Netherlands BV**
**5504 DR Veldhoven (NL)**

(72) Inventor: **Chen, Alek Chi-Heng**
**Xindian City**
**Taipei Country (TW)**

(74) Representative: **Leeming, John Gerard**
**J.A. Kemp & Co.,**
**14 South Square,**
**Gray's Inn**
**London WC1R 5JJ (GB)**

(54) **Substrate, lithographic multiple exposure method, machine readable medium**

(57)     A method for imaging using a lithographic system includes decomposing a desired pattern to be printed on the substrate into at least two constituent sub-patterns that are capable of being optically resolved by the lithographic system, coating a substrate a substrate with a stack of two sacrificial hard masks on top of a target layer which is to be patterned with the desired dense line pattern. To provide suitable etch stop layers, the material of the sacrificial mask layers and the target layer is chosen such that for each etching step, the etching between two exposures and the etching of the target layer have alternating selectivities.

**Fig 1**

EP 1 744 211 A1

**Description**

The present invention generally relates to photolithography and associated methods and apparatus for exposing semiconductor substrates.

Lithographic exposure apparatuses can be used, for example, in the manufacture of integrated circuits (ICs). In such a case, a patterning device may generate a circuit pattern corresponding to an individual layer of the IC. In photolithography, a beam of radiation is patterned by having that beam traverse the patterning device, and is projected by a projection system of the lithographic apparatus onto a target portion (e.g., comprising one or more dies) on a substrate (silicon wafer) that has been coated with a layer of photo-activated resist (i.e., photoresist) material, such as to image the desired pattern in the resist. In general, a single wafer will contain a whole network of adjacent target portions that are successively irradiated via the projection system, one at a time.

In the semiconductor industry, the continual demand for smaller semiconductor devices, having smaller patterns and features on the wafer substrate, is pushing the limits on the optical resolution that can be achieved by lithographic exposure apparatus. Generally, the smallest size of repeatable feature (e.g., "half-pitch") of a pattern exposed on the wafer substrate that can be optically resolved by lithographic exposure apparatus, depends on attributes of the projection system and the (patterned) projection beam of radiation. In particular, the optical resolution for half-pitch feature size may be derived by using the simplified form of the Rayleigh resolution equation:

$$p_{0.5} = k_1 \bullet \lambda / \text{NA, with } k_1 \geq 0.25 \qquad (1)$$

where:

$p_{0.5}$ represents the repeatable feature size (*e.g.*, "half-pitch") in nm;
NA represents the numerical aperture of projection system;
$\lambda$ represents the wavelength of projection beam; and
$k_1$ is a factor representative for the achievable optical resolution limit for the half-pitch feature size.

As indicated above, the theoretical optical resolution half-pitch lower limit for $k_1$ is 0.25. In an attempt to circumvent the $k_1$ = 0.25 barrier, considerable efforts have been directed to develop expensive technologies that are capable of employing shorter wavelengths and/or higher numerical apertures, thus allowing production of smaller features while not violating the $k_1 \geq 0.25$ constraint.

For printing contact holes or trenches, it is known that circumvention of the $k_1$ = 0.25 barrier is possible by applying a double exposure lithographic process, whereby a desired pattern to be printed is decomposed into two constituent sub-patterns that are capable of being optically resolved by the lithographic system. Using a positive tone resist a first resist mask is provided on a hard mask layer, in accordance with the first sub-pattern of contact holes, followed by etching a target layer (using the first resist mask) to transfer the first sub pattern to the hard mask. Next, the first resist mask is stripped from the target layer and a second resist mask is provided on the target layer, in accordance with the second sub-pattern of contact holes, followed by a second etching of the target layer (using the second resist mask). As a result, the first and second sub-pattern images are combined to produce a desired pattern on the target layer. Such a process is suitable for printing contact holes and trenches where the imaging process is of optimal quality when imaging bright features (the contacts and/or trenches) against a dark background, but cannot be used for printing lines below the $k_1$ = 0.25 barrier. For printing lines, the imaging process is of optimal quality when imaging dark lines against a bright background, and the use of a negative resist would be called for (further omitting the intermediate etch step between the two exposures). However, the imaging properties of negative resists are inferior with respect to the imaging properties of positive resist.

A method consistent with the principles of the present invention, as embodied and broadly described herein, provides for the enhancement of image resolution in a lithographic system. There is provided a substrate comprising a target layer constructed and arranged to be lithographically patterned with a desired pattern, and a stack of hard mask layers at least partially overlying the target layer and comprising a first hard mask layer at least partially overlying the target layer and a second hard mask layer at least partially overlying the first hard mask layer, wherein the first hard mask layer and the second hard mask layer have a mutually exclusive etch resistance and wherein one of the first hard mask layer and the second hard mask layer comprises an oxide and the other hard mask layer comprises a nitride.

According to an aspect of the invention, there is provided a lithographic multiple exposure method of exposing a lithographic substrate having a target layer and a stack of hard mask layers at least partially overlying the target layer and including a first hard mask layer at least partially overlying the target layer and a second hard mask layer at least partially overlying the first hard mask layer, the method comprising transferring a first pattern to the second hard mask layer by a first lithographic process comprising an etching of said second hard mask layer to provide a corresponding first pattern of features protruding from the first hard mask layer, and transferring a second pattern to the first hard mask layer, in interlaced position with respect to the first pattern of features, by a second lithographic process comprising an etching of said first hard mask layer to provide a further protrusion of the first pattern of features from the target layer, and to provide a second pattern of features protruding from the target layer in accordance with the second pattern.

According to an aspect of the invention, there is provided a lithographic multiple exposure method of exposing a lithographic substrate having a target layer and a stack of hard mask layers at least partially overlying the target layer and including a first hard mask layer at least partially overlying the target layer and a second hard mask layer at least partially overlying the first hard mask layer, the method comprising transferring a first pattern to the second hard mask layer by a first lithographic process comprising an etching of said second hard mask layer to provide a corresponding first pattern of features protruding from the first hard mask layer, and transferring a second pattern to the first hard mask layer, in interlaced position with respect to the first pattern of features, by a second lithographic process comprising an etching of said first hard mask layer to provide a further protrusion of the first pattern of features from the target layer, and to provide a second pattern of features protruding from the target layer in accordance with the second pattern.

In an embodiment of the invention the first and second etching have an alternating, mutually substantially exclusive selectivity, in particular a nitride to oxide selectivity.

According to another aspect of the invention there is provided machine readable medium encoded with machine executable instructions for patterning a substrate according to a method comprising:

identifying the etch resistance of a target layer of a substrate, of a first hard mask layer at least partially overlying the target layer, and of a second hard mask layer at least partially overlying the first hard mask layer, wherein the first hard mask layer and the second hard mask layer have a mutually exclusive etch resistance,

transferring a first pattern to the second hard mask layer by a first lithographic process comprising a first exposure of a resist layer provided on the second hard mask,

determining a gas mixture for use with dry etching of the second hard mask layer while using the first hard mask layer as an etch stop, in accordance with said identified etch resistances,

applying said dry etching of said second hard mask layer using said determined gas mixture,

transferring a second pattern in interlaced registry with respect the first pattern , to the first hard mask layer by a second lithographic process comprising a second exposure of a resist layer provided on the first hard mask,

determining a second gas mixture for use with dry etching of the first hard mask layer while using the target layer as an etch stop, in accordance with said identified etch resistances,

applying said dry etching of said first hard mask layer using said determined second gas mixture.

Here, the second pattern is exposed in interlaced registry with respect to the first pattern to provide an etch mask for use with patterning the target layer in accordance with a desired pattern.

According to another aspect of the invention there is provided a lithographic cluster comprising a lithographic exposure apparatus, an etch chamber capable of etching a mask layer on a substrate, and a control device for controlling the lithographic exposure apparatus and the etch chamber, whereby the control device is arranged to execute said first etching and second etching according to the method of the present invention.

Embodiments of the invention will now be described, by way of example only, with reference to the accompanying schematic drawings in which corresponding reference symbols indicate corresponding parts, and in which:

Figure 1 illustrates a substrate prepared for use with the method, provided with a target layer and two sacrificial mask layers;

Figure 2 illustrates the decomposition of a dense line pattern which is beyond lithographic resolution into two semi dense line patterns which each are within lithographic resolution;

Figure 3 shows a flow scheme of a double exposure method according to the present invention;

Figure 4 illustrates the effect of etching steps of Figure 3, in accordance with the present invention;

Figure 5 illustrates a lithographic cluster according to an embodiment of the present invention, and

Figure 6 depicts a lithographic apparatus according to an embodiment of the invention.

As noted above, their exists a constant need to achieve finer optical resolutions and circumventing the theoretical half-pitch lower limit $k_1$ of 0.25 for printing lines using positive tone resist would provide an important advantage. Without this possibility, to achieve resolutions below this limit, efforts generally concentrate on the development of expensive technologies that employ shorter wavelengths and/or higher numerical apertures.

As described in greater detail below, the present invention achieves resolutions lower than the half-pitch lower limit half pitch $p_{0.5} = k_1 \cdot \lambda / NA$ whereby $k_1 \geq 0.25$, thus circumvention the $k_1 = 0.25$ barrier, by implementing a multiple exposure technique with a preselected combination of a plurality of hard mask layers, whereby the hard mask layers are stacked in accordance with an alternating sequence of etch stop functionality. In particular, the present invention enables the exclusive use of positive tone resist for printing those features in place of negative tone resist, and whereby $k_1 < 0.25$. Examples of such features are dense, semi dense and isolated lines whereby $k_1 < 0.25$.

In the manufacture of integrated circuits (ICs) lithographic exposure apparatuses are used, in which case a patterning device such as a mask (a "reticle") generates a circuit pattern corresponding to an individual layer of the IC. In photolithography, a beam of radiation is patterned by having that beam traverse the reticle, and is projected by a projection system of the lithographic apparatus onto a target portion (*e.g.*, comprising one or more dies) on a substrate W, a silicon wafer, that has been coated with a layer of photo-activated resist (i.e., photoresist) material, such as to image the desired pattern in the resist. In general, a single wafer W will contain a whole network of adjacent target portions that are successively irradiated via the projection system, one at a time.

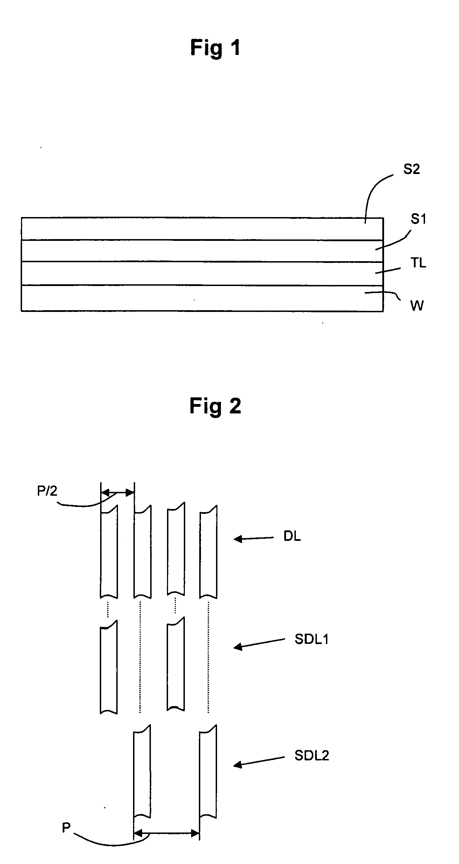

According to the invention, and as illustrated in Figure 1, there is provided a substrate W, which may carry previously processed IC layers, and which is provided, in the following order, with a target layer TL, a first sacrificial hard mask layer S 1, and a second sacrificial mask layer S2. The stack of hard mask layers is referred to as the S2-S1-TL stack.

As schematically illustrated in Figure 2, the desired pattern to be printed comprises a set DL of dense lines arranged at a pitch P/2. This set DL is decomposed into two constituent sub-patterns SDL1 and SDL2 of semi-dense lines each arranged at a pitch P, that are capable of being optically resolved by the lithographic system. It is to be appreciated that the features are not limited to being lines or segments of lines as illustrated in Figure 2. The desired features in the target layer TL can, for example, be an array of arbitrarily shaped portions of target-layer protruding from the surface of the substrate W, whereby the features of the pattern DL are disposed as elements of an array arranged at a pitch P/2. The sub-patterns SDL1 and SDL2 then include corresponding arrays of said arbitrarily shaped portions of target-layer protruding from the surface of the substrate W, wherein the features SDL1 and SDL2 are disposed as elements of respective arrays arranged at a pitch P. The portions of target layer material which embody the features of the sub-patterns SDL1 and SDL2 are, in an embodiment of the present invention, disposed in an interlaced manner in the desired pattern DL.

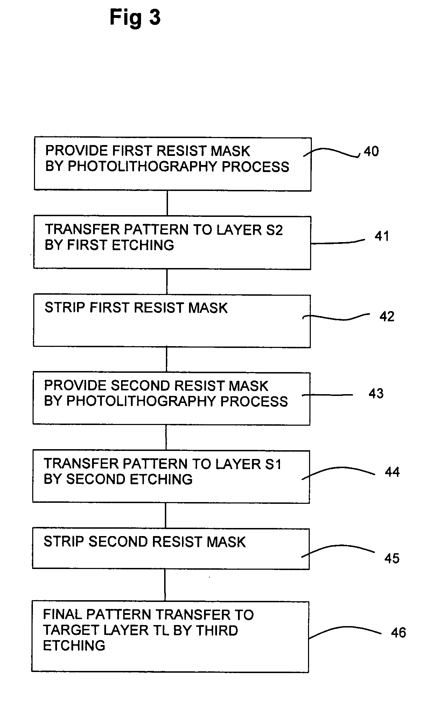

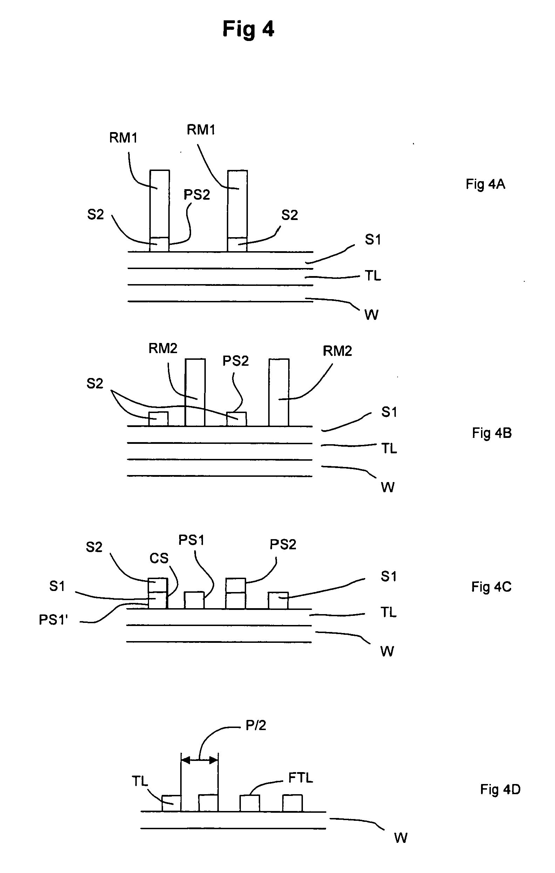

Figure 3 and Figure 4 illustrate the different steps of the method in more detail. Using a positive tone resist, for example suitable for use with DUV radiation generated by an ArF excimer laser with a wavelength of 193 nm, a first resist-mask RM 1, see Figure 4A, is provided on the second sacrificial hard mask material layer S2, in accordance with the first sub-pattern SDL1 of semi dense lines, and a first etching is executed, *i.e.*, the etching of the sacrificial hard mask S2 (using the first resist-mask) is executed to transfer the first sub-pattern to the second hard mask S2. This is represented by the steps 40 and 41 in Figure 3. The effect of the first etching is illustrated in Figure 4A, where portions PS2 of mask layer S2 material (and arranged at pitch P) are protruding from mask layer S1, and where between the portions PS2 the mask layer S2 is removed.

Next, the first resist-mask is stripped away, step 42 in Figure 3, and a second positive tone resist (which may be the same as the previously used positive tone resist) is applied, step 43 in Figure 3, to the substrate and is used to provide (by exposure and resist development) a second resist-mask RM2 on the first sacrificial hard mask S 1 in areas between the portions PS2, in accordance with the second sub-pattern SDL2 of semi dense lines. The step includes positioning a mask provided with a pattern in accordance with the sub-pattern SDL2 in a position whereby the projected image of the mask pattern is interlaced with respect to the pattern provided to the second sacrificial hard mask layer S2. The result of the first resist-mask stripping and the application of the second resist-mask RM2 is shown in Figure 4B. Subsequently, step 44 includes applying a second etching, *i.e.*, the etching of the first sacrificial hard mask S 1 (using as etch mask the features PS2 in the second sacrificial hard mask S2 as well as the applied second resist-mask RM2). As illustrated in Figure 4C, portions PS1 of first mask layer S 1 material are protruding from the target layer TL and disposed at a pitch P on the target layer in accordance with the sub-pattern SDL2, and similar portions PS1' of first mask layer S 1 are obtained by the etch resistivity of the previously obtained portions PS2 to the etching of the first mask layer S1. In accordance with an embodiment of the present invention, there is provided, as a result of the second etching, a hard mask patterned in accordance with the desired pattern DL, including interlaced protruding features in accordance with interlaced sub-patterns SDL1 and SDL2, wherein walls defining a space between two neighbouring features are formed by a side of one protruding feature of the sub-pattern SDL1, the protruding feature comprising a stack of mask layer portions PS 1' and PS2 having a common side wall CS and by a side of the neighbouring, protruding feature of the pattern SDL2, the neighbouring protruding feature comprising a mask layer portion PS2. It is appreciated that an embodiment of the present invention is characterized by providing, at this stage of the process, two interlaced sub-patterns of equal "tone", i.e., both sub-patterns are patterns of protruding material features. A subsequent stripping away of the second resist mask RM2 corresponds to step 45 in Figure 3.

As a result, a transfer of the first and second sub-pattern images such as to provide a hard mask of features protruding from the upper surface of the target layer TL in Figure 4C and corresponding to the desired combined pattern DL in the first sacrificial hard mask layer S 1 (and on the target layer TL) is obtained.

A final pattern transfer, see step 46 in Figure 3, which can be part of the previous pattern transfer in an integrated etch chamber, is obtained by applying a third etching, i.e., the etching of the target layer TL wherein the protruding features in Figure 4C are used as an etch mask. After removing the remaining portions of hard mask material layers S 1 and S2, a pattern DL of features FTL in the target layer TL protruding from the upper surface of the substrate W is obtained. Figure 4D illustrates this result - the features FTL are disposed at a pitch P/2 in accordance with the desired pattern DL.

Where reference is made to providing a resist-mask in each of the lithographic exposure processes, such providing a resist-mask comprises, after having coated the substrate with the photoresist layer, exposing the target area of the substrate W with one of the sub-patterns SDL1 and SDL2 by patterning a beam of radiation at reticle level with the corresponding selected sub-pattern and imaging this beam of radiation such that the lithographic system produces a corresponding sub-pattern image at the photoresist layer. This exposure step is followed by developing the exposed resist, to produce the corresponding resist-mask in accordance with the selected sub-pattern. The providing a resist-mask may further include a variety of processes before and/or after exposure of the resist layer. For example, pre-exposure processes may include cleaning, priming, and soft bake processes. After exposure, the wafer substrates may be subjected to a different post-exposure processes, such as, for example, a post exposure bake (PEB), and a hard bake. Where in the present text and claims reference is made to "providing a resist mask," said providing may include, besides execution of an exposure, the execution of one or more suitable lithographic pre-exposure or post-exposure processing steps. Further, any photoresist layer may include a Bottom Anti Reflex Coating or a Developable Bottom Anti Reflex Coating to reduce back reflection of exposure radiation.

An aspect of the invention is that the method is suitable for printing dense and semi dense lines because the method involves the use of positive tone resist for the transfer of the patterns SDL 1 and SDL2 to the target layer TL. An imaging process for printing lines is of optimal quality when imaging dark lines against a bright background. With the present invention this optimal quality can be obtained by using positive resist with the lithographic processes for printing the line features of the resist masks RM1 and RM2, whereby unexposed positive resist remains insoluble during development of the resist. An aspect of the present invention is that lines are printed, instead of spaces. Alignment errors between the two exposures do not affect the resulting printed line width, but only the spaces, which is generally less critical to, for example, transistor performance. A placement error between the sub-patterns SDL1 and SDL2, *i.e.,* the overlay consistency between the two exposures of the double exposure process, has no effect on the printed CD of the resulting lines. This placement error can be of the order of the placement error as occurring during the mask writing process.

The lithographic exposure apparatus used for printing the lines generally comprises a support structure constructed to support a patterning device (*e.g.*, a mask), and a substrate table (*e.g.*, a wafer table) constructed to hold the substrate W. The lithographic exposure apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure. Residual placement errors during e-beam writing of the masks for the patterns SDL1 and SDL2 can be monitored and in a dual stage lithographic projection system these residual errors can be compensated for when the dual stage apparatus is used in a mode of operation whereby he scanner "remembers" the wafer chuck used for the first exposure and dedicates the same wafer chuck for the second exposure. This mode of operation will be referred to hereinafter as the chuck-dedication-mode. As a result, in the chuck-dedication-mode, the wafer stepping grid and the wafer table chucking induced distortions fingerprints will be the same for the first and second exposures. This reduces non-correctable higher order overlay errors between these two exposures. In addition, the low order e-beam mask writer's pattern placement errors, *e.g.*, linear offsets and magnification errors, between two masks can be compensated in the scanner by using the appropriate alignment compensations for the wafer stage and the reticle stage. In the chuck-dedication-mode the overlay performance with the present double exposure process is comparable to, or even better than the mask-writer's placement accuracy. An other aspect of the invention is that by using positive resist with the lithographic processes for printing the lines of the patterns SDL1 and SDL2 any overlay error of the patterns SDL1 and SDL2, and hence also of the resulting pattern DL, with respect to a pattern which was previously formed on the substrate W is the same as would have been obtained with a single exposure process. In other words, the resulting alignment accuracy of the pattern DL in the target layer TL with respect to a reference on the substrate W directly corresponds to the alignment accuracy obtainable with a single-exposure process.

Due to any non-linearity of the response of a photoresist layer to either development and/or exposure, the spatial Fourier transformation of the resist-masks (corresponding to the sub-patterns SDL1 and SDL2 and as obtained by the development of the resist) contain higher spatial frequencies than the spatial Fourier transformation of the intensity pattern of the images of the sub-patterns SDL1 and SDL2. The resist-masks and etching steps fix the sub-pattern images in the respective hard mask layers, thus preventing a cross talk or a merging of the two sub-pattern images corresponding to the patterns SDL1 and SDL2. Therefore, also the spatial Fourier transformation of the combined pattern DL as transferred to the target layer contains spatial frequencies higher than corresponding to the inverse of a half pitch $p$ 0.5 = $k_1 \cdot \lambda$ / NA whereby $k_1 \geq 0.25$, which enables the circumvention of the $k_1$ = 0.25 barrier.

The required etching and cleaning of the target layer between the first and second exposure and after the second exposure of a conventional double exposure lithographic process necessitates providing one or more etch chambers within a lithographic cluster. Here the lithographic cluster is the group of apparatus comprising etch chambers, the lithographic apparatus and a coat/develop track that is typically linked to the lithographic apparatus. For large geometries, typically wet-etching devices are used, whereas for critical geometries of the order of the spatial resolution limit of the lithographic process dry etching chambers, suitable for reactive ion etching, are used. Reactive Ion Etching, also referred to as RIE, involves low pressure processing in a pressure range of for example 100 mtor - 10 mtor. An advantage of RIE is that it is a non-isotropic, directionally selective etch process, whereas wet etching is an isotropic etch process (causing undercut of features).

According to an aspect of the present invention, the S2-S1-TL stack is subjected to (at least) two etchings whereby each time the RIE technology is used. The etch sequence is described below.

In the following, material of the first sacrificial mask layer S 1 may be referred to as S1-material, and similarly, material of the second sacrificial mask layer S2 and the target layer TL may be referred to as, respectively, S2-material and TL-material.

During a first etching, the S2-S1-TL stack is etched such that:

S2-material of the second sacrificial mask layer is selectively taken away (as a result of directionally etching away S2-material around the first resist-mask RM1)
to form a first hard mask pattern in the second sacrificial mask layer S2, and on the first sacrificial mask layer S1, in accordance with the SDL1 pattern. The S1-material of the first sacrificial mask layer serves as etch stop.

After stripping the first resist-mask RM1 the features of the first hard mask pattern consist of S2-material.

The stack of hard mask layers in areas where the first etch was stopped by the S1-material, is referred to as the S1-TL stack.

During a second etching, the S1-TL stack is etched such that:

S1-material of the first sacrificial mask layer is selectively taken away (as a result of directionally etching away S 1-material around the second resist mask as well as around the first hard mask pattern)
to form a second hard mask pattern, in the first sacrificial mask layer S1, and on the target layer TL, in accordance with the combined pattern DL. The S2-material of the second sacrificial mask layer as well as TL-material serve as etch stop.

After stripping the second resist mask, the features of the second hard mask pattern comprise:

features consisting of stacked S2-material and S1-material (as a result of etching away S1 material around the features of the first hard mask pattern), in accordance with the SDL1 pattern, and
features consisting of S 1 material (as a result of directionally etching away S 1 inaterial around the second resist mask RM2) in accordance with the SDL2 pattern.

In the present embodiment, the first and second etching have a mutually exclusive (or at least a substantially mutually exclusive) selectivity: the etching sequence is:

selectively etching S2-material, with S1-material serving as etch stop (the first etching), and
selectively etching S1-material, with S2-material serving as etch stop, (the second etching).

According to an aspect of the invention, the material of the target layer TL may be the same as the material of the second sacrificial mask layer S2. Consequently, during a third etching, the target layer may be etched such that:

S2-material of the target layer TL is selectively taken away (as a result of directionally etching away S2-material around the second hard mask pattern),
to form a final hard mask pattern in the target layer TL, and on the substrate W, in accordance with the dense line pattern DL. The surface material of the substrate W serves as etch stop.

The features of the final hard mask pattern consist of S2-material.

So, in this embodiment, the etching sequence is:

selectively etching S2-material, with S1-material serving as etch stop (the first etching),
selectively etching S1-material, with S2-material serving as etch stop, (the second etching) and finally selectively etching S2 material again (the final etching).

Consequently, the required etch selectivity is alternating between selectivity to S 1 material and selectivity to S2 material.

In any of the above embodiments, the S2-material is, for example, a nitride, and the S1-material is, for example, an oxide. For example, S2-material may be plasma enhanced chemical vapour deposition (PECVD) silicon nitride ($Si_3N_4$) and S1-material may be PECVD silicon dioxide ($SiO_2$). However, the invention is not limited to the use of these materials for the sacrificial mask layers. Alternatively, in any of the above embodiments the S1- and S2-material are interchanged: the S2-material is PECVD silicon dioxide ($SiO_2$), and the S1-material is PECVD silicon nitride ($Si_3N_4$).

According to a further aspect of the invention the target layer TL may an IC-layer (such as for example a doped polysilicon layer).

According to an aspect of the invention, three or even more exposures can be used to combine three or more corresponding sub-patterns into a final pattern to be provided to the target layer, analogous to the double exposure method described above. A multiple exposure method as described above, whereby the providing said second hard mask layer further comprises providing one or more additional hard mask layers and whereby said first etching is preceded by a corresponding sequence of one or more additional etchings of said one or more additional hard mask layers is possible and can be used to transfer a first sub-pattern, a second sub-pattern and a corresponding set of one or more additional sub-patterns to a target layer, whereby all sub patterns are positioned in interlaced registry to form a desired combined pattern. For example, when a desired pattern to be transferred to the target layer is split up in a first, a second and a third sub-pattern, the second hard mask (as described in the double exposure embodiment above) may be further provided with a third hard mask. By a first exposure, the third hard mask is provided with a first resist-mask in accordance with the first sub-pattern, followed by a first etching, i.e., the etching of the third sacrificial hard mask (using the first resist-mask) to transfer the first sub-pattern to the third hard mask. Next, the first resist-mask is stripped away from the third hard mask, positive tone resist is applied to the substrate, is exposed (the second exposure) and is used to provide a second resist-mask on the second sacrificial hard mask, in accordance with the second sub-pattern, followed by a second etching, *i.e.,* the etching of the second sacrificial hard mask (using the second resist-mask). Finally, the second resist-mask is stripped away from the second hard mask, positive tone resist is applied to the substrate and by applying a third exposure it is used to provide a third resist-mask on the first sacrificial hard mask, in accordance with the third sub-pattern, followed by a third etching, *i.e.,* the etching of the first sacrificial hard mask (using the third resist-mask). Analogous to the double exposure embodiment, the first sacrificial hard mask carries the desired combined pattern.

In the embodiment describing the double exposure method above, the terminology "first etching" was used for describing the etching of the second hard mask and "second etching" was used for describing the etching of the first hard mask. In the appended claims this terminology is maintained. For the present triple exposure embodiment, to maintain this terminology the etching of the third hard mask is identified as an etching preceding a "first etching" of the second hard mask.

Again, in analogy with the double exposure embodiment, the etching sequence is a selectively etching the third sacrificial hard mask, with material of the second sacrificial hard mask serving as etch stop, followed by a selectively etching the second hard mask, with material of the first hard mask serving as etch stop, and finally a selectively etching the first hard mask, with material of the target layer serving as etch stop.

According to an aspect of the invention said one or more additional etchings and said first and second etchings have an alternating, mutually exclusive selectivity.

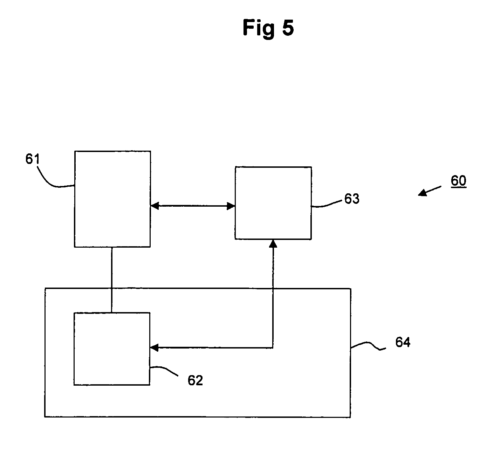

As explained above, a lithographic cluster suitable for use with conventional double exposure processes generally comprises a plurality of etch chambers. According to an aspect of the present invention, and as illustrated in Figure 5, a lithographic cluster 60 comprises, besides a lithographic exposure apparatus 61, an etch chamber 62 capable of etching the sacrificial mask layers S 1 and S2, and a control device 63 for controlling the lithographic exposure apparatus and the etch chamber, whereby the control device is arranged to execute the first and second etchings according to the embodiments described above (see the process steps 41 and 44 in Figure 3) in a single etch chamber. The use of a single etch chamber 63 for these process steps alleviates the problem of having to provide and control a plurality of etch chambers for each separate etching step. The etch chamber may be part of a wafer track 64, and the control device may be part of the lithographic exposure apparatus 61 or the wafer track 64. The etch chamber and the wafer track in the present embodiment are linked to the lithographic exposure apparatus, and the control device communicates with both the lithographic exposure apparatus and the etch chamber, as illustrated by the double sided arrows in Figure 5.

Successive etching with mutually exclusive selectivities in a single etch chamber can be accomplished by the use of a dry etching chamber, for example arranged for executing reactive ion etching. An alternating high etch selectivity (for example alternating between selectivity to oxide and selectivity to nitride) can be achieved using a dielectric plasma etch process. According to an aspect of the invention a single, inductively coupled high-density plasma reactor is used for etching hard masks such as for example the mask layers S 1 and S2, and/or the target layer TL. With plasma reactors of the latter type a change of etch selectivity can be obtained by providing a change of gas components in the etch chamber between the successive etchings. According to an aspect of the invention, the lithographic cluster comprises a plurality dry etching chambers, each capable of switching etch selectivity in this way, to provide sufficient throughput of processed substrates.

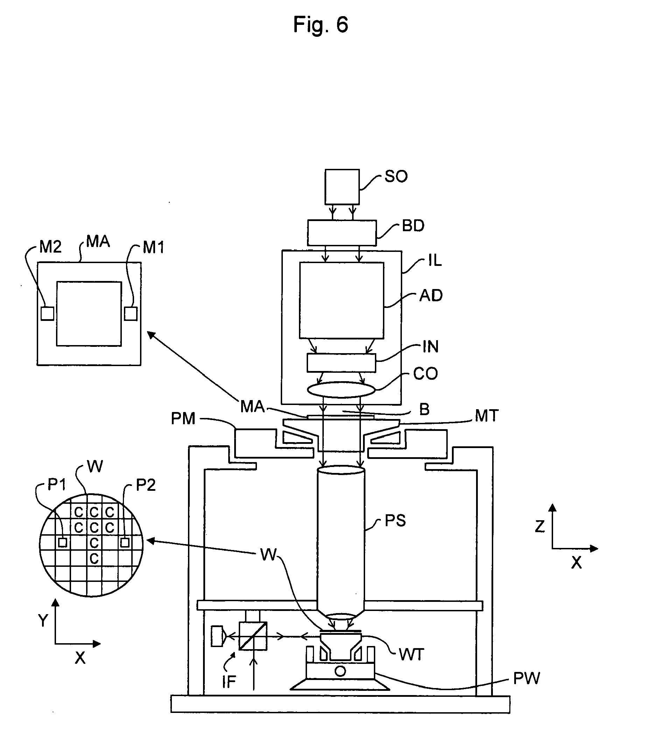

A lithographic exposure apparatus according to an embodiment of the invention is schematically depicted in Figure 6. The apparatus comprises:

an illumination system (illuminator) IL configured to condition a radiation beam B (e.g., UV radiation or DUV radiation such as for example generated by an excimer laser operating at a wavelength of 193 nm or 157 nm, or EUV radiation generated by a laser-fired plasma source operating at 13,6 nm).

a support structure (*e.g.*, a mask table) MT constructed to support a patterning device (*e.g.,* a mask) MA and connected to a first positioner PM configured to accurately position the patterning device in accordance with certain parameters;

a substrate table (*e.g.*, a wafer table) WT constructed to hold a substrate (*e.g.*, a resist-coated wafer) W and connected to a second positioner PW configured to accurately position the substrate in accordance with certain parameters; and

a projection system (*e.g.*, a refractive projection lens system) PS configured to project a pattern imparted to the radiation beam B by patterning device MA onto a target portion C (*e.g.*, comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit. The patterning device may be transmissive or reflective.

The term "projection system" used herein should be broadly interpreted as encompassing any type of projection system, including refractive, reflective, and catadioptric optical systems, or any combination thereof, as appropriate for the exposure radiation being used, or for other factors such as the use of an immersion liquid or the use of a vacuum. Any use of the term "projection lens" herein may be considered as synonymous with the more general term "projection system."

As here depicted, the apparatus is of a transmissive type (*e.g.*, employing a transmissive mask). Alternatively, the apparatus may be of a reflective type (*e.g.*, employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, *e.g.*, water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 6, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as $\sigma$-outer and $\sigma$-inner, respectively)

of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (*e.g.*, mask table MT), and is patterned by the patterning device. Having traversed the mask MA, the radiation beam B passes through the projection system PS, which focuses the beam onto a target portion C of the substrate W. With the aid of the second positioner PW and position sensor IF (*e.g.*, an interferometric device, linear encoder or capacitive sensor), the substrate table WT can be moved accurately, *e.g.*, so as to position different target portions C in the path of the radiation beam B. Similarly, the first positioner PM and another position sensor (which is not explicitly depicted in Figure 6) can be used to accurately position the mask MA with respect to the path of the radiation beam B, *e.g.*, after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:

1. In step mode, the mask table MT and the substrate table WT are kept essentially stationary, while an entire pattern imparted to the radiation beam is projected onto a target portion C at one time (i.e., a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the radiation beam is projected onto a target portion C (*i.e.,* a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

According to an aspect of the invention the lithographic cluster comprises, as lithographic exposure apparatus, a lithographic interferometry apparatus. In such an apparatus, a resist layer is exposed to a fringe pattern obtained in a multiple beam interferometric apparatus. For example, two collimated beams of UV or DUV radiation intersect each other at an angle to produce linear interference fringes. A wafer having a photosensitive layer is positioned on a movable table. The table is arranged to be rotated and translated in two-dimensions respectively. Two substantially collimated coherent optical beams provided by any suitable well known source or sources are directed at a variable angle from the normal vector associated with the wafer toward each other and toward the photoresist layer to form an interference pattern on the photosensitive layer. The interfering radiation beams of coherent radiation may be generated by, for example, an ArF excimer laser using a beam splitting element, and may be provided in any suitable well known manner so that they are from the same source and are essentially equal in intensity at the wafer which assures a high contrast exposure.

The interference pattern produced on the photoresist layer or layers may be varied by for example rotating the wafer and/or translating the wafer.

A control device according to the present invention may comprise a memory into which data can be stored which concern sub-patterns such as the sub-patterns SDL1 and SDL2 and which are used for controlling the lithographic exposure apparatus (such as, for example, settings concerning positioning of the stages MT and WT, and/or settings concerning illumination modes) during each of the exposures used to generate the combined pattern DL. The same memory can be used to store data concerning the settings of the etch chamber used for etching the sacrificial hard mask layers S 1 and S2 (such as, for example, pressure, gas mixture composition, and temperature). A computer which may be part of the control device is programmed and arranged to execute, based on the data stored in the memory, any of the method steps according to the present invention, such as for example the steps 40 to 46 of Figure 3. The execution of the steps involves running a computer program on said computer, said computer program containing one or more sequences of machine-readable instructions describing any of the methods as disclosed above. The computer contains a machine readable medium (e.g., semiconductor memory, magnetic or optical disk) having such a computer program stored therein.

According to an aspect of the invention the machine readable medium is encoded with machine executable instructions for patterning a substrate according to the following steps. A substrate provided with a target layer TL and the stack of the first and second hard mask layers S 1 and S2, is provided to the lithographic cluster, which may involve a substrate handler transporting the substrate to the lithographic exposure apparatus. The first hard mask layer and second hard mask layer have a mutually exclusive etch resistance. Next the etch resistance of the second and first hard mask layers, and of the target layer, are identified, for example by reading user supplied data concerning the substrate to be exposed. Subsequently, the lithographic cluster is controlled to execute a patterning of the second hard mask layer by a first lithographic process comprising a first exposure with a first sub-pattern of a resist layer provided on the second hard mask, and determining and supplying a gas mixture to the etch chamber, said gas mixture suitable for use with dry etching of the second hard mask layer while using the first hard mask layer as etch stop, in accordance with said identified etch resistances. The selection of the gas mixture is determined, for example by making a selection from an a priori given set of gas mixtures. By next applying said dry etching of said second hard mask layer using said determined gas mixture, the second hard mask layer is patterned.

This sequence of steps is repeated for patterning the first hard mask layer by a second lithographic process comprising a second exposure with a second sub-pattern of a resist layer provided on the first hard mask, determining a second gas mixture for use with dry etching of the first hard mask layer while using the target layer as etch stop, in accordance with said identified etch resistances, and applying said dry etching of said first hard mask layer using said determined second gas mixture (step 706 in Figure 7). During the second exposure the second sub-pattern is exposed in juxtaposed registry with respect to the first sub-pattern (*i.e.,* the image of the first sub-pattern) to provide a hard mask patterned in accordance with the desired pattern as illustrated in Figure 4C.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion," respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (*e.g.*, having a wavelength of or about 365, 355, 248, 193, 157 or 126 nm) and extreme ultraviolet (EUV) radiation (*e.g.*, having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described.

The descriptions above are intended to be illustrative, not limiting. Thus, it will be apparent to one skilled in the art that modifications may be made to the invention as described without departing from the scope of the claims set out below.

**Claims**

1.  A substrate comprising:

       a target layer constructed and arranged to be lithographically patterned with a desired pattern; and
       a stack of hard mask layers at least partially overlying the target layer and comprising a first hard mask layer at least partially overlying the target layer and a second hard mask layer at least partially overlying the first hard mask layer, wherein the first hard mask layer and the second hard mask layer have a mutually exclusive etch resistance and wherein one of the first hard mask layer and the second hard mask layer comprises an oxide and the other hard mask layer comprises a nitride.

2. A substrate according to claim 1 wherein the respective compositions of the first and second hard mask layers, and the composition of the target layer alternates between comprising an oxide and comprising a nitride.

3. A method of exposing a lithographic substrate having a target layer and a stack of hard mask layers at least partially overlying the target layer and including a first hard mask layer at least partially overlying the target layer and a second hard mask layer at least partially overlying the first hard mask layer, the method comprising:

transferring a first pattern to the second hard mask layer by a first lithographic process comprising an etching of said second hard mask layer to provide a corresponding first pattern of features protruding from the first hard mask layer; and
transferring a second pattern to the first hard mask layer, in interlaced position with respect to the first pattern of features, by a second lithographic process comprising an etching of said first hard mask layer to provide a further protrusion of the first pattern of features from the target layer, and to provide a second pattern of features protruding from the target layer in accordance with the second pattern.

4. A method according to claim 3, wherein the etchings of the first and second hard mask layer have a mutually exclusive selectivity.

5. A method according to claim 4, wherein one of the mutually exclusive selectivities is a nitride selectivity and the other mutually exclusive selectivity is an oxide selectivity.

6. A method according to claim 3, 4 or 5 wherein the second hard mask layer is a silicon nitride layer and the first hard mask layer is a silicon dioxide layer.

7. A method according to claim 3, 4 or 5 wherein the first hard mask layer is a silicon nitride layer and the second hard mask layer is a silicon dioxide layer.

8. A method according to claim 3, 4, 5, 6 or 7 wherein the first and second lithographic processes each further comprise applying positive tone resist to the substrate.

9. A method according to any one of claims 3 to 8 wherein a desired pattern comprises a first sub-pattern and a second sub-pattern, and wherein
the transferring by the first lithographic process comprises exposing resist to an image of the first sub-pattern, and the transferring by the second lithographic process comprises exposing resist to an image of the second sub-pattern which is arranged in interlaced registry with respect to the image of the first sub-pattern to form the desired pattern on the substrate.

10. A method according to claim 9 wherein the transferring by the first lithographic process comprises exposing positive tone resist to a first line pattern image and the transferring by the second lithographic process comprises exposing positive tone resist to a second line pattern image arranged in interlaced position on the substrate with respect to the first line pattern image.

11. A method according to any one of claims 3 to 10 wherein the etchings of the first and second hard mask layer each comprise a dielectric plasma etch process.

12. A method according to any one of claims 3 to 11 further comprising an etching of said target layer wherein the first and second patterns of features substantially act as an etch stop.

13. A method according to claim 12, wherein the etchings of the first and second hard mask layer and the target layer have an alternating, mutually exclusive selectivity.

14. A method according to claim 13 wherein the alternating, mutually exclusive selectivity is alternating between a nitride selectivity and an oxide selectivity.

15. A method according to any one of claims 3 to 14 wherein the second hard mask layer further comprises one or more additional hard mask layers and wherein a corresponding sequence of one or more additional etchings of said one or more additional hard mask layers precedes said first etching.

16. A method according to claim 15, wherein said one or more additional etchings and said first and second etchings have an alternating, mutually exclusive selectivity.

17. A computer program comprising instructions that, when executed by a machine, instruct the machine to pattern a substrate according to a method comprising:

identifying respective etch resistances of a target layer of a substrate, of a first hard mask layer at least partially overlying the target layer, and of a second hard mask layer at least partially overlying the first hard mask layer, wherein the first hard mask layer and the second hard mask layer have a mutually exclusive etch resistance; transferring a first pattern to the second hard mask layer by a first lithographic process comprising a first exposure of a resist layer provided on the second hard mask; determining a gas mixture for use with dry etching of the second hard mask layer while using the first hard mask layer as an etch stop, in accordance with said identified etch resistances; dry etching said second hard mask layer using said determined gas mixture; transferring a second pattern in interlaced registry with respect to the first pattern to the first hard mask layer by a second lithographic process comprising a second exposure of a resist layer provided on the first hard mask; determining a second gas mixture for use with dry etching of the first hard mask layer while using the target layer as an etch stop, in accordance with said identified etch resistances; dry etching said first hard mask layer using said determined second gas mixture.

18. A lithographic cluster comprising a lithographic exposure apparatus, an etch chamber capable of dry etching a mask layer on a substrate, and a control device configured to control the lithographic exposure apparatus and the etch chamber, wherein the control device comprises the computer program according to claim 17.

19. A lithographic cluster according to claim 18 wherein the etch chamber capable of dry etching is arranged to execute reactive ion etching.

20. A lithographic cluster according to claim 19 wherein the reactive ion etching is a dielectric plasma etch process.

21. A lithographic cluster according to claim 18, wherein the etch chamber capable of dry etching is an inductively coupled high-density plasma reactor.

22. A lithographic cluster according to claim 21 wherein the etch chamber capable of dry etching is capable of switching etch selectivity by a corresponding change of gas components comprised within the dry etching chamber.

23. A lithographic cluster according to any one of claims 18 to 22 wherein the lithographic exposure apparatus is one of a lithographic projection apparatus and a lithographic interferometry apparatus.

# Fig 1

S2

S1

TL

W

# Fig 2

P/2

DL

SDL1

SDL2

P

# Fig 3

| PROVIDE FIRST RESIST MASK BY PHOTOLITHOGRAPHY PROCESS | 40 |

| TRANSFER PATTERN TO LAYER S2 BY FIRST ETCHING | 41 |

| STRIP FIRST RESIST MASK | 42 |

| PROVIDE SECOND RESIST MASK BY PHOTOLITHOGRAPHY PROCESS | 43 |

| TRANSFER PATTERN TO LAYER S1 BY SECOND ETCHING | 44 |

| STRIP SECOND RESIST MASK | 45 |

| FINAL PATTERN TRANSFER TO TARGET LAYER TL BY THIRD ETCHING | 46 |

# Fig 4

Fig 4A

Fig 4B

Fig 4C

Fig 4D

# Fig 5

# Fig. 6

**European Patent Office**

**EUROPEAN SEARCH REPORT**

Application Number

EP 06 25 3492

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/025670 A1 (MIYATA KOJI [JP]) 28 February 2002 (2002-02-28) * paragraph [0007] - paragraph [0019]; figure 3 * | 1,2 | INV. G03F7/00 |
| X | US 2004/209486 A1 (NAEEM MUNIR D [US] ET AL) 21 October 2004 (2004-10-21) * paragraph [0050] - paragraph [0054]; figure 8 * | 1,2 | |
| X | JP 63 132446 A (MITSUBISHI ELECTRIC CORP) 4 June 1988 (1988-06-04) | 1,2 | |
| Y | * abstract * | 5-7,11, 14,16 | |
| X | WO 00/59030 A (COMMISSARIAT ENERGIE ATOMIQUE [FR]; TROUILLER YORICK [FR]; DEMOLLIENS) 5 October 2000 (2000-10-05) | 1,2 | |
| Y | * the whole document * | 5-7,11, 14,16 | |
| X | US 5 902 493 A (BAE SANG MAN [KR]) 11 May 1999 (1999-05-11) | 3,4, 8-10,12, 13,17-23 | TECHNICAL FIELDS SEARCHED (IPC) G03F H01L |
| Y | * the whole document * | 5-7,11, 14,16 | |
| X | WO 02/095498 A2 (KONINKL PHILIPS ELECTRONICS NV [NL]; DIRKSEN PETER [NL]; JUFFERMANS CA) 28 November 2002 (2002-11-28) * the whole document * | 3,8-10, 15,17-23 | |

The present search report has been drawn up for all claims

| Place of search | Date of completion of the search | Examiner |
|---|---|---|
| The Hague | 15 November 2006 | Haenisch, Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**    EP 06 25 3492

This annex lists the patent family members relating to the patent documents cited in the above-mentioned European search report.
The members are as contained in the European Patent Office EDP file on
The European Patent Office is in no way liable for these particulars which are merely given for the purpose of information.

15-11-2006

| Patent document cited in search report | | Publication date | Patent family member(s) | | Publication date |
|---|---|---|---|---|---|
| US 2002025670 | A1 | 28-02-2002 | JP | 2002026122 A | 25-01-2002 |
|  |  |  | TW | 492151 B | 21-06-2002 |
| US 2004209486 | A1 | 21-10-2004 | NONE | | |
| JP 63132446 | A | 04-06-1988 | JP | 1877626 C | 07-10-1994 |
|  |  |  | JP | 5087142 B | 15-12-1993 |
| WO 0059030 | A | 05-10-2000 | EP | 1177577 A1 | 06-02-2002 |
|  |  |  | FR | 2791472 A1 | 29-09-2000 |
| US 5902493 | A | 11-05-1999 | JP | 9181059 A | 11-07-1997 |
|  |  |  | KR | 223325 B1 | 15-10-1999 |
| WO 02095498 | A2 | 28-11-2002 | CN | 1474960 A | 11-02-2004 |
|  |  |  | JP | 2004520723 T | 08-07-2004 |
|  |  |  | TW | 565881 B | 11-12-2003 |
|  |  |  | US | 2006160029 A1 | 20-07-2006 |
|  |  |  | US | 2004146808 A1 | 29-07-2004 |

EPO FORM P0459